# EUROPEAN PATENT APPLICATION

(11) **EP 4 521 868 A1**
(43) Date of publication of application: **12.03.2025**
(21) Application number: 23196089.9
(22) Date of filing: 07.09.2023
(51) Int. Cl.: H05K 7/20

(54) **ELECTRONIC DEVICE**

(71) Applicant: Valeo Comfort and Driving Assistance, 94000 Créteil (FR)
(72) Inventor: HALMANDGE, Veerappa, 94000 Créteil (FR); REICHERT, Walter, 94000 Créteil (FR)
(74) Representative: Delplanque, Arnaud

(57) **Abstract**

The invention relates to an electronic device comprising an electronic circuit board (15) enclosed in a housing comprising a first part (2) facing a first face of the electronic circuit board and a second part (3) facing a second face of the electronic circuit board opposite to the first face, the first part (2) comprising a first airflow channel (7) extending parallel to the first face between a first inlet and a first outlet, the second part comprising a second airflow channel (8) extending parallel to the second face between a second inlet and a second outlet, the first airflow channel and the second airflow channel being fed by a same airflow source.

## Description

The invention belongs to the technical field of electronic devices, and relates specially to electronic devices used in automotive vehicles, for instance telecommunication devices used for telematic operations in cars. In particular, the invention concerns an electronic device.

### BACKGROUND INFORMATION AND PRIOR ART

Telematic control units are embedded electronic systems that perform telecommunication operations, for instance telephony operations and emergency calls. Telematic control unit usually comprise a housing fixed to the bodywork of the vehicle.

It is known that the electronic components of the telematic control unit may heat. In order to prevent the electronic component from reaching temperatures that could damage it, several solutions exist.

For instance, some solutions comprise an air channel in the top part of the housing which is fed by a fan. The air provided by the fan allow to cool down the electronic components. However, these solutions are, in some conditions, insufficient.

### SUMMARY OF THE INVENTION

Therefore, one object of the invention is to provide an electronic device that can be efficiently cooled down.

According to an aspect of the invention, it is provided an electronic device comprising an electronic circuit board enclosed in a housing comprising a first part facing a first face of the electronic circuit board and a second part facing a second face of the electronic circuit board opposite to the first face, the first part comprising a first airflow channel extending parallel to the first face between a first inlet and a first outlet, the second part comprising a second airflow channel extending parallel to the second face between a second inlet and a second outlet, the first airflow channel and the second airflow channel being fed by a same airflow source.

Thanks to the second channel, the electronic circuit board may be cool down from each side. The heat dissipation of the electronic device is therefore improved. Moreover, the use of a single airflow source to feed the two channels simplify the electronic device. The electronic device is thus lighter and smaller.

According to an embodiment, the first outlet and the second inlet are connected to each other so that the first channel and the second channel form a continuous channel extending in the first part and in the second part.

Thanks to this feature, the airflow provided by the airflow source is fully transmitted in each of the two channels. No division of the airflow occurs. The cooling of the electronic device is thus improved.

According to an embodiment, at least one of the first channel and second channel comprises a proximal wall relatively to the electronic circuit board, the proximal wall being in contact with a component of the electronic circuit board.

According to an embodiment, the proximal wall comprises a plurality of heat dissipation fins extending longitudinally in the channel.

According to an embodiment, the proximal wall comprised aluminium.

According to an embodiment, at least one of the first channel and second channel comprises a distal wall relatively to the electronic circuit board, the distal wall being a removable cover.

According to an embodiment, the airflow source is a radial fan located in one of the first channel and second channel.

According to an embodiment, the airflow source is located at the first inlet.

According to an embodiment, the electronic device is a telematic control unit.

### DETAILED DESCRIPTION OF EXAMPLE(S)

The following description with reference to the accompanying drawings will make it clear what the invention consists of and how it can be achieved. The invention is not limited to the embodiment illustrated in the drawings. Accordingly, it should be understood that where features mentioned in the claims are followed by reference signs, such signs are included solely for the purpose of enhancing the intelligibility of the claims and are in no way limiting on the scope of the claims.

In the accompanying drawings:
- figure 1 is a cross sectional schematic view of an electronic device according to an embodiment of the invention,
- figure 2 is a schematic view of the electronic device of figure 1 from a first point of view,
- figure 3 is another schematic view of the electronic device of figure 1 from the first point of view,
- figure 4 is a schematic view of the electronic device of figure 1 from a second point of view,
- figure 5 is another schematic view of the electronic device of figure 1 from the second point of view.

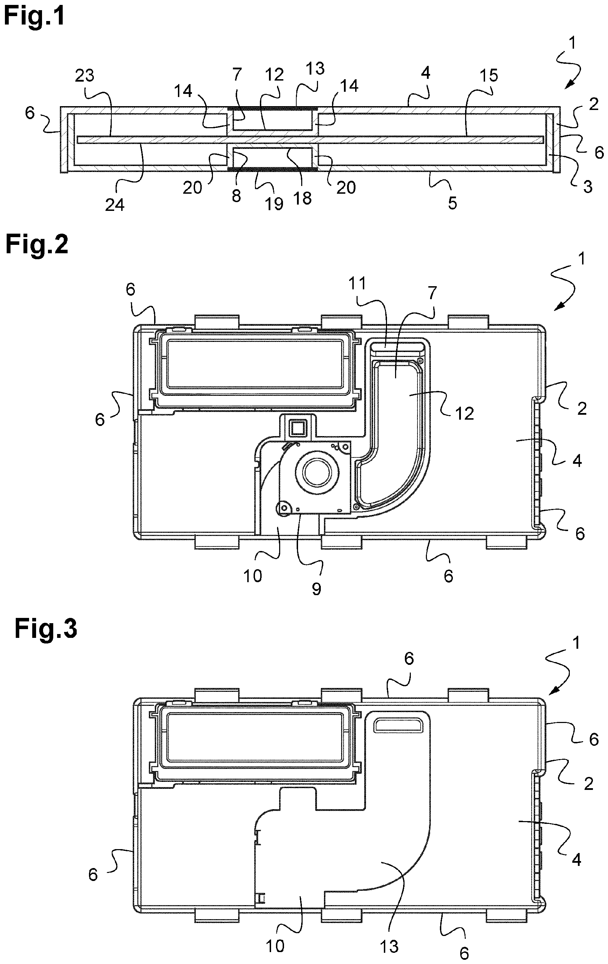

An electronic device according to an embodiment of the invention, as shown in figure 1 and designated as a whole by the general reference 1, comprises an electronic circuit board 15 enclosed in a housing comprising a first part 2 and a second part 3.

For instance, the electronic device 1 is a telematic control unit configured to be placed in an automotive vehicle and to communicate with a distant network. For instance, the second part 3 is configured to be fixed against the bodywork of the automotive vehicle.

The first part 2 faces a first face 23 of the electronic circuit board and the second part faces a second face 24 of the electronic circuit board 15 opposite to the first face 23.

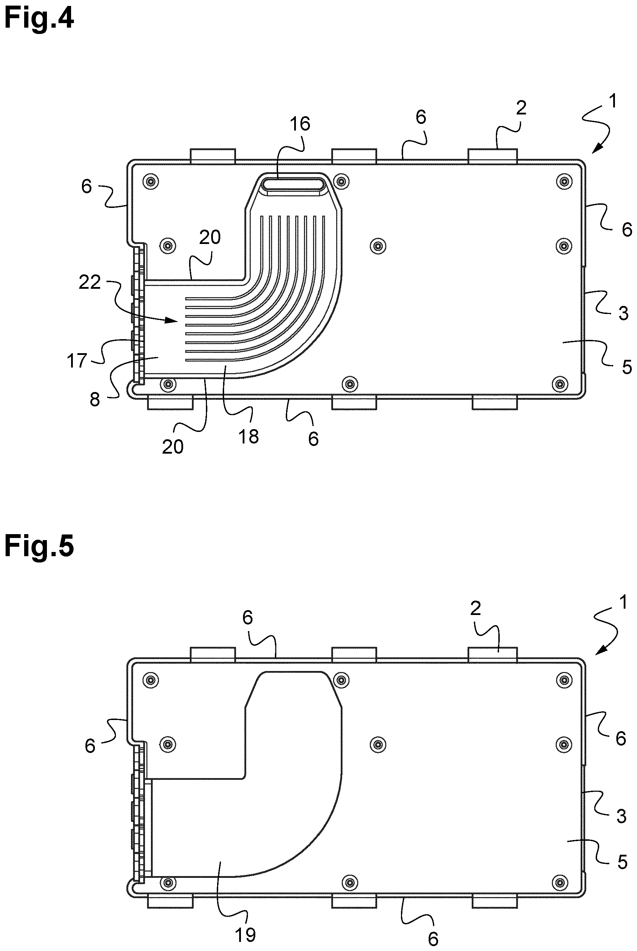

Here, the electronic device 1 presents a globally parallelepipedal shape with a first main face 4 (visible on figures 1 to 3) belonging to the first part 2, a second main face 5 (as visible on figures 1, 4 and 5) opposite and parallel to the first main face 4 and belonging to the second part 3. The first main face 4 and the second main face 5 are connected by four side faces 6. For instance, the side faces are formed by the first part 2 and/or by the second part 3. Here, the first part 2 and the second part 3 are fixed to each other, for instance clipped to each other.

The electronic circuit board 15 is placed in the housing in such manner that a first face of the electronic circuit board 15 is parallel with the first main face 4 and a second face of the electronic circuit board 15 opposite to the first face is parallel to the second main face 5.

During operation of the electronic device 1, the electronic circuit board 15 may overheat and may be damaged. In order to avoid the overheating of the electronic circuit board 15, the electronic device 1 comprise a heat dissipation system, comprising a first airflow channel 7 in the first part 2 of the housing and a second airflow channel 8 in the second part of the housing. The first airflow channel 7 and the second airflow channel 8 are both fed by a same airflow source 9, here a radial fan.

The first airflow channel 7 extends in the first part 2 parallel to the electronic circuit board 15 between a first inlet 10 and a first outlet 11 (the wording "inlet" and "outlet" being dependent on the airflow direction). Here, the first airflow channel 7 is not linear along the path followed by the airflow and forms a right angle.

Here, the first airflow channel 7 presents a rectangular cross section. It therefore comprises four walls, among which a first proximal wall 12 relatively to the electronic circuit board 15 (the wall which is closer to the electronic circuit board 15), a first distal wall 13 (the farthest wall from the electronic circuit board 15), and two first side wall 14 extending between the proximal wall and the distal wall.

Here, the first distal wall 13 comprises a first removable cover configured to be placed over the first channel 7.

The first proximal wall 12 is in contact with the electronic circuit board 15. In this example, the first proximal wall 12 comprised a material having a high thermal conductivity, for instance a metal and preferably aluminium.

Here, the first inlet 10 is located on a side face 6 and the first outlet 11 is located in a portion of the first proximal wall that is not in contact with the electronic circuit board 15 and that extends beyond the outline of the electronic circuit board 15.

The airflow source 9 is located in the first airflow channel 7, here near the first inlet 10.

In order to improve the thermal dissipation of the electronic circuit board 15, the electronic device 1 comprises a second airflow channel 8 located in the second part of the housing.

The second airflow channel 8 extends in the second part 3 parallel to the electronic circuit board 15 between a second inlet 16 and a second outlet 17. Here, the second airflow channel 8 is not linear along the path followed by the airflow and forms a right angle.

Here, the second airflow channel 9 presents a rectangular cross section. It therefore comprises four walls, among which a second proximal wall 18 relatively to the electronic circuit board 15 (the wall which is closer to the electronic circuit board 15), a second distal wall 19 (the farthest wall from the electronic circuit board 15), and two second side wall 20 extending between the second proximal wall 18 and the second distal wall 20.

Here, the second distal wall 19 comprises a second removable cover configured to be placed over the second channel 8.

The second proximal wall 18 is in contact with the electronic circuit board 15. In this example, the second proximal wall 18 comprised a material having a high thermal conductivity, for instance a metal and preferably aluminium. In this example, a plurality of heat dissipation fins 22, here eight heat dissipation fins, extends longitudinally in the second channel 8. The heat dissipation fins 22 protrudes from the second proximal wall 12, and are integrally formed with the second proximal wall 18.

Here, the second outlet 17 is located on a side face 6 and the second inlet 16 is located in a portion of the second proximal wall that that extends beyond the outline of the electronic circuit board 15, in vis-à-vis with the first outlet 11. The first outlet 11 and the second inlet 16 are connected and the first channel 7 and the second channel 8 forms a continuous channel extending in the first part 2 and in the second part 3.

Preferably, the first part 2 and the second part 3 are made in material that can easily be moulded, stamped, or die-casted. For instance, the first part (excepted the first removable cover) is obtained by stamping of a first material and the second part (excepted the second removable cover) is obtain by die-casting of a second material. The removable covers are preferably in a material similar as the material of their corresponding parts.

The invention is not limited to the embodiments described in relation to Figures 1 to 5.

In particular, it has been previously described an airflow source located in the first channel, near the first inlet. The location of the airflow source is not limitative, and the airflow source may be located in the first or second channel, near any inlet or outlet, or at distance from the inlet and outlet, or outside the channel near an inlet or an outlet.

Also, it has been described one of the two channels comprising eight heat dissipation fins. The invention is not limited by this number of fins, and other embodiments comprise a different number of fins or no fins at all. In some embodiments, both channels are provided with heat dissipation fins.

The housing according to the invention may be made in any material. For instance, in order to increase thermal dissipation, at least one of the first part and second part is made in a material having a good thermal conductivity, for instance a metal and preferably aluminium. In some embodiments, at least one of the proximal walls are made in a material that is different from the material of their corresponding parts.

## Claims

1. An electronic device comprising an electronic circuit board (15) enclosed in a housing (2,3) comprising a first part (2) facing a first face (23) of the electronic circuit board (15) and a second part (3) facing a second face (24) of the electronic circuit board (15) opposite to the first face (23), the first part (2) comprising a first airflow channel (7) extending parallel to the first face (23) between a first inlet (10) and a first outlet (11), the second part (3) comprising a second airflow channel (8) extending parallel to the second face (24) between a second inlet (16) and a second outlet (17), the first airflow channel (7) and the second airflow channel (8) being fed by a same airflow source (9).

2. The electronic device according to claim 1, wherein the first outlet (11) and the second inlet (16) are connected to each other so that the first channel (7) and the second channel (8) form a continuous channel extending in the first part (2) and in the second part (3).

3. The electronic device according to claim 1 or 2, wherein at least one of the first channel (7) and second channel (8) comprises a proximal wall (12, 18) relatively to the electronic circuit board (15), the proximal wall (12, 18) being in contact with a component of the electronic circuit board (15).

4. The electronic device according to claim 3, wherein the proximal wall (18) comprises a plurality of heat dissipation fins (22) extending longitudinally in the channel.

5. The electronic device according to claim 3 or 4, wherein the proximal wall (12, 18) comprised aluminium.

6. The electronic device according to any one of claims 1 to 5, wherein at least one of the first channel (7) and second channel (8) comprises a distal wall (13, 19) relatively to the electronic circuit board (15), the distal wall (13, 19) being a removable cover.

7. The electronic device according to any one of claim 1 to 6, wherein the airflow source (9) is a radial fan located in one of the first channel (7) and second channel (8).

8. The electronic device according to any one of claims 1 to 7, wherein the airflow source (9) is located at the first inlet (10).

9. Electronic device according to anyone of claims 1 to 8, wherein the electronic device (1) is a telematic control unit.
